# EUROPEAN PATENT SPECIFICATION

(11) **EP 4 380 001 B1**
(45) Date of publication and mention of the grant of the patent: **04.11.2026**
(21) Application number: 23835778.4
(22) Date of filing: 03.07.2023
(51) Int. Cl.: H02J 11/00, H03K 17/22, H02J 7/00

(54) **BATTERY SYSTEM COMPRISING WAKE-UP CIRCUIT**
BATTERIESYSTEM MIT AUFWECKSCHALTUNG
SYSTÈME DE BATTERIE COMPRENANT CIRCUIT DE RÉVEIL

(30) Priority: 06.07.2022 KR 20220083198
(43) Date of publication of application: 05.06.2024
(73) Proprietor: LG Energy Solution, Ltd., Seoul 07335 (KR)
(72) Inventor: JO, Yongmin, Daejeon 34122 (KR)
(74) Representative: BCKIP Part mbB
(86) International application number: PCT/KR2023/009347
(87) International publication number: WO 2024/010312

(56) References cited:
- CN-A- 113 328 453
- CN-A- 113 507 156
- JP-A- 2008 220 151
- KR-A- 20120 020 704
- KR-B1- 101 029 941
- KR-B1- 101 457 986
- US-A1- 2010 327 960
- US-A1- 2015 254 206
- US-A1- 2018 208 066

## Description

### [Technical Field]

### CROSS-REFERENCE TO RELATED APPLICATION

This application claims priority to and the benefit of Korean Patent Application No. 10-2022-0083198 filed in the Korean Intellectual Property Office on July 06, 2022.

The present disclosure relates to a wake-up circuit and a battery system including the same.

### [Background Art]

In order to wake up a battery system, a transceiver for each of the battery system and external systems controlling the battery system, a main control unit, etc. need to operate. In a sleep mode, the battery system does not perform a charging or discharging operation, but is in a standby state for performing a wake-up operation according to a wake-up signal received from an external system. Although an amount of standby power consumed by the battery system in the standby state is small, when the standby time is long, the amount of standby power increases, making it difficult to maintain the battery system in the sleep mode for a long period of time. In particular, it is difficult to manage the battery system in the sleep mode for a long period of time in a low-temperature period or region. Therefore, it is necessary to reduce the standby power of the battery system in the sleep mode. CN 113328453 A shows a switch sleep awakening circuit having a wake-up circuit for managing a battery management system unit unit of an energy storage system. The wake-up circuit is provided with a CAN signal input module, wherein a voltage difference between the CAN buses causes an optical coupler switch to be turned on and charging a capacitor and when the capacitor has enough power a first MOS is turned on, which then turns a second MOS on and a DC/DC power supply module supplies power for a MCU.

### [Disclosure]

### [Technical Problem]

The present disclosure attempts to provide a battery system including a wake-up circuit capable of reducing standby power in a sleep mode.

### [Technical Solution]

A battery system according to claim 1 is provided.

### [Advantageous Effects]

There is provided a battery system including a wake-up circuit capable of reducing standby power in a sleep mode.

### [Description of the Drawings]

FIG. 1 is a schematic diagram illustrating a battery system according to an exemplary embodiment.
FIG. 2 is a diagram illustrating a wake-up circuit for the battery system.
FIG. 3 is a diagram illustrating a part of a wake-up circuit according to an example.
FIG. 4 is a waveform diagram illustrating two CAN bus voltages, a wake-up holding signal, and a relay open signal according to an exemplary embodiment.

### [Mode for Invention]

The suffixes "module" and "unit" for components used in the description below are assigned or mixed in consideration of easiness in writing the specification and do not have distinctive meanings or roles by themselves. In addition, the terms "-er", "-or", and "module" described in the specification refer to units for processing at least one function and operation, which may be implemented by hardware, software or a combination thereof.

In addition, in describing exemplary embodiments disclosed in the present specification, detailed descriptions of relevant known technologies will be omitted if they unnecessarily obscure the gist of the exemplary embodiments disclosed in the present specification. Further, the accompanying drawings are provided only to help easily understand exemplary embodiments disclosed in the present specification. It should be understood that the technical idea disclosed in the present specification is not limited by the accompanying drawings, and includes all modifications, equivalents, and substitutions within the spirit and the technical scope of the present disclosure.

Terms including ordinal numbers such as first and second may be used to describe various components, but these components are not limited by these terms. These terms are used only for the purpose of distinguishing one component from another component.

It is to be understood that when one component is referred to as being "connected to" or "coupled to" another component, one component may be connected or coupled directly to another component or be connected or coupled to another component with an intervening component therebetween. On the other hand, it is to be understood that when one component is referred to as being "directly connected to" or "directly coupled to" another component, one component may be connected to another component with no intervening component therebetween.

It should be understood that terms "include", "have", and the like used in the present application specify the presence of features, numerals, steps, operations, components, parts, or combinations thereof mentioned in the specification, but do not preclude the presence or addition of one or more other features, numerals, steps, operations, components, parts, or combinations thereof.

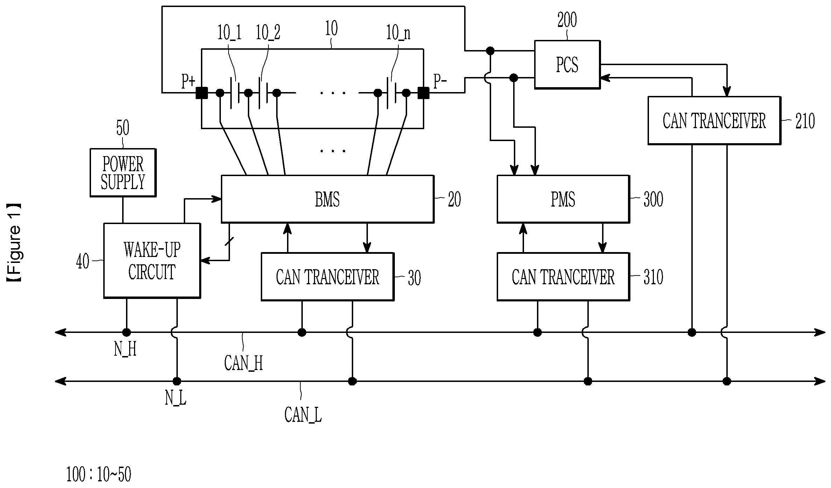

FIG. 1 is a schematic diagram illustrating a battery system according to an exemplary embodiment.

In FIG. 1, a battery system 100 is connected to a power conversion system (PCS) 200. The power conversion system 200 may receive energy from the battery system 100 to supply power to an electrical load, or may convert energy supplied from the outside to charge the battery system 100. A power management system (PMS) 300 may control a power conversion operation of the power conversion system 200. For example, the power conversion operation controlled by the power management system 300 may include a power conversion operation for the power conversion system 200 to convert energy supplied from the battery system 100 and output the converted energy, or a power conversion operation for the power conversion system 200 to convert energy input thereto and supply the converted energy to the battery system 100. To this end, the power management system 300 may be connected to both terminals P+ and P- of the battery system 100, and may transmit a signal for controlling a power conversion operation to the power conversion system 200. In addition, the power management system 300 may receive feedback information necessary for controlling a power conversion operation from the power conversion system 200. The battery system 100 may be an energy storage system (ESS).

As illustrated in FIG. 1, the battery system 100, the power conversion system 200, and the power management system 300 may transmit and receive information required for control to and from each other through CAN communication. To implement CAN communication, each system includes a CAN transceiver, and each CAN transceiver is connected to two CAN buses CAN_H and CAN_L. The battery system 100 may include a CAN transceiver 30, and the CAN transceiver 30 may transmit and receive digital data to and from a battery management system (BMS) 20. The power conversion system 200 transmits and receives digital data to and from a CAN transceiver 210, and the power management system 300 transmits and receives digital data to and from a CAN transceiver 310. Each of the CAN transceivers 30, 210, and 310 may convert the digital data received from the system connected thereto into two voltages, which are differential signals, transmit the two voltages to the two CAN buses CAN_H and CAN_L, respectively, generate digital data based on a difference between the two voltages received from the two CAN buses CAN_H and CAN_L, and transmit the generated digital data to the corresponding system. Specifically, each CAN transceiver may detect a voltage difference between the two CAN buses CAN_H and CAN_L, convert the detected voltage difference into digital data, and receive corresponding information by identifying the content of a message using an identifier among the converted digital data. Each CAN transceiver may transmit two voltages obtained by converting digital data to the two CAN buses (CAN_H, CAN_L) according to a ranking corresponding to an assigned ID.

The CAN communication through a CAN network between the battery system 100, the power conversion system 200, and the power management system 300 illustrated in FIG. 1 is an example for explaining the disclosure, but the disclosure is not limited thereto. The present disclosure may be applied to various CAN communication schemes using two CAN buses to which two voltages, which are known differential signals, are transmitted.

The battery system 100 includes a battery pack 10, a battery management system 20, a CAN transceiver 30, a wake-up circuit 40, and a power supply 50.

The battery pack 10 illustrated in FIG. 1 includes a plurality of battery cells 10_1 to 10_n, (where n is a natural number greater than or equal to 2) connected to each other in series. In FIG. 1, the battery pack 10 is illustrated as including n battery cells 10_1 to 10_n connected to each other in series, but this is an example and the disclosure is not limited thereto. For example, a plurality of units of two or more battery cells connected in parallel may be connected to each other in series. Alternatively, a plurality of units of a plurality of battery cells connected in series may be connected to each other in parallel. Both terminals P+ and P- of the battery pack 10 may be connected to the power conversion system 200. Through the both terminals P+ and P-, energy may be supplied from the battery pack 10 to the power conversion system 200, or energy may be supplied from the power conversion system 200 to the battery pack 10.

The battery management system 20 may be connected to the plurality of battery cells 10_1 to 10_n to detect a cell voltage for each of the plurality of battery cells 10_1 to 10_n, a battery current of the battery pack 10, a temperature of the battery pack 10, and the like, control a charge/discharge current of the battery pack 10 based on the detected information, and control cell balancing operations for the plurality of battery cells 10_1 to 10_n. When the battery management system 20 is woken up, a control operation is performed to connect the battery management system 20 to the power supply 50 through the wake-up circuit 40. To this end, the battery management system 20 generates a wake-up holding signal HS and a relay open signal RO.

The CAN transceiver 30 may convert digital data received from the battery management system 20 into two voltages, which are differential signals, and transmit the two voltages to the two CAN buses CAN_H and CAN_L, respectively. The CAN transceiver 30 may convert a difference between the two voltages received from the two CAN buses CAN_H and CAN_L into digital data. When the converted digital data is a message that the battery management system 20 needs to receive, the message may be transmitted to the battery management system 20.

The power supply 50 supplies power for waking up the battery management system 20. The power supply 50 may be connected to the battery pack 10 to generate a power voltage of a constant level using a voltage of the battery pack 10. Alternatively, the power supply 50 may generate a power voltage of a constant level using a voltage from a separate battery distinct from the battery pack 10.

When the difference between the two voltages received from the two CAN buses CAN_H and CAN_L indicates that the battery management system 20 needs to be woken up, the wake-up circuit 40 connects the battery management system 20 to the power supply 50.

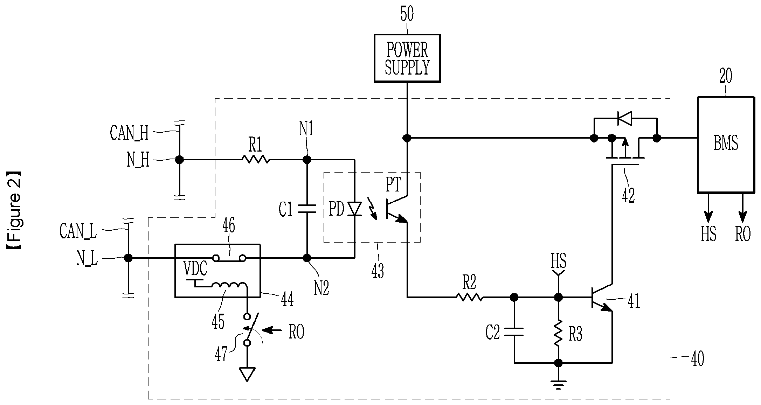

Hereinafter, the wake-up circuit 40 will be described with reference to FIG. 2.

FIG. 2 is a diagram illustrating a wake-up circuit for the battery system.

The wake-up circuit 40 includes a control transistor 41, a power transistor 42, and an optocoupler 43. A wake-up signal is transmitted to the control transistor 41 through the optocoupler 43, and the control transistor 41 is turned on according to the wake-up signal. When the control transistor 41 is turned on, the power transistor 42 is turned on, such that the power supply 50 is connected to the battery management system 20. The battery management system 20 is woken up by the power voltage supplied from the power supply 50.

The optocoupler 43 includes a photodiode PD and a phototransistor PT. An anode of the photodiode PD is connected to a contact N1, and a cathode of the photodiode PD is connected to a contact N2. A capacitor C1 is connected between the contact N1 and the contact N2, and a resistor R1 is connected between the CAN bus CAN_H and the contact N1. One end of the resistor R1 is connected to the CAN bus CAN_H at a contact N_H, and the other end of the resistor R1 is connected to the contact N1. A relay 44 is connected between the contact N2 and a contact N_L. One end of the relay 44 is connected to the CAN bus CAN_L at the contact N_L, and the other end of the relay 44 is connected to the contact N2. The relay 44 includes an inductor 45 and a switch 46, and the switch 46 may be basically in a closed state and opened when a current flows through the inductor 45.

The resistor R1 and the capacitor C1 may form a low-pass filter, and a voltage difference between a voltage of the CAN bus CAN_H and a voltage of the CAN bus CAN_L (hereinafter referred to as a CAN bus voltage difference) may be transmitted to the photodiode PD through the low-pass filter. The low-pass filter including the resistor R1 and the capacitor C1 is connected in parallel to the photodiode PD. To wake up the battery management system 20, the CAN bus voltage difference is greater than or equal to a predetermined voltage. For example, the power management system 300 may transmit a relatively high voltage of a predetermined level to the CAN bus CAN_H and transmit a relatively low voltage of a predetermined level to the CAN bus CAN_L through the CAN transceiver 310. At this time, the CAN bus voltage difference is greater than or equal to a level (threshold level) at which the photodiode PD is turned on. When the photodiode PD is turned on due to the CAN bus voltage difference, a current flows through the photodiode PD, and the photodiode PD emits light. When the photodiode PD emits light, the phototransistor PT is turned on. The phototransistor PT remains turned on during a period in which the photodiode PD emits light, and the photodiode PD emits light during a period in which the CAN bus voltage difference is greater than or equal to the threshold level.

A collector of the phototransistor PT is connected to the power supply 50, and an emitter of the phototransistor PT is connected to a base, which is a control terminal, of the control transistor 41. The control transistor 41 is implemented by an npn BJT. A resistor R2 is connected between the emitter of the phototransistor PT and the base of the control transistor 41, and a capacitor C2 is connected between the base of the control transistor 41 and the ground. The resistor R2 and the capacitor C2 may form a low-pass filter. A collector of the control transistor 41 is connected to a gate, which is a control terminal, of the power transistor 42, and an emitter of the control transistor 41 is connected to the ground. A resistor R3 is connected between the base and the emitter of the control transistor 41 to maintain a voltage difference between the base and the emitter. A source of the power transistor 42 is connected to the power supply 50, and a drain of the power transistor 42 is connected to the battery management system 20.

During a period in which the phototransistor PT is turned on, the control transistor 41 is turned on, and the gate of the power transistor 42 may be connected to the ground through the control transistor 41 that is in the turn-on state to turn on the power transistor 42. When the power transistor 42 is turned on, the voltage of the power supply 50 is supplied to the battery management system 20.

The relay 44 is opened when a switch 47 is turned on. Specifically, the switch 46 is connected between the contact N2 and the contact N_L, a voltage VDC is supplied to one terminal of the inductor 45, the other terminal of the inductor 45 is connected to one terminal of the switch 47, and the other terminal of the switch 47 is connected to the ground. The switch 47 is turned on according to a relay open signal RO at a turn-on level. When the switch 47 is turned on, a current may flow through the inductor 45 to open the switch 46.

A wake-up holding signal HS is supplied to the base of the control transistor 41. During a period in which the wake-up holding signal HS is at a turn-on level, the control transistor 41 is maintained in a turn-on state.

In FIG. 2, the relay 44 is illustrated as being connected between the contact N2 and the contact N_L, but the disclosure is not limited thereto. The relay may be connected between the contact N1 and the contact N_H.

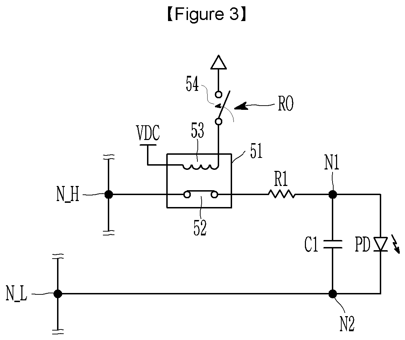

FIG. 3 is a diagram illustrating a part of a wake-up circuit according to an example.

As illustrated in FIG. 3, a relay 51 is connected between the contact N1 and the contact N_H. The relay 51 includes a switch 52 and an inductor 53. The switch 52 is connected between the contact N1 and the contact N_H, a voltage VDC is supplied to one terminal of the inductor 53, the other terminal of the inductor 53 is connected to one terminal of a switch 54, and the other terminal of the switch 54 is connected to the ground. The switch 54 is turned on according to a relay open signal RO at a turn-on level. When the switch 47 is turned on, a current may flow through the inductor 53 to open the switch 52.

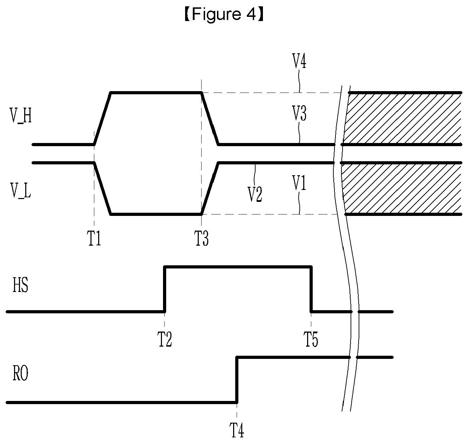

Hereinafter, a wake-up operation will be described with reference to FIG. 4.

FIG. 4 is a waveform diagram illustrating two CAN bus voltages, a wake-up holding signal, and a relay open signal according to an exemplary embodiment.

As illustrated in FIG. 4, at time T1, a first voltage V_H of the CAN bus CAN_H rises and a second voltage V_L of the CAN bus CAN_L drops. For example, the first voltage V_H rises from voltage V3 to voltage V4, and the second voltage V_L drops from voltage V2 to voltage V1. The voltage V2 and the voltage V3 may be at the same level. When the CAN bus voltage difference, which is a voltage difference between the first voltage V_H and the second voltage V_L, is greater than or equal to the threshold level, the photodiode PD emits light and the phototransistor PT is turned on. Then, the power transistor 42 is turned on such that the power supply 50 supplies a voltage to the battery management system 20, as described above. The battery management system 20 is woken up by the voltage supplied from the power supply 50, and may perform necessary operations such as monitoring the battery pack 10 after being woken up. In addition, the battery management system 20 generates a wake-up holding signal HS at a turn-on level at time T2. The time T2 illustrated in FIG. 4 may be any time within a period from the time when the battery management system 20 is woken up to time T3.

At time T3, the first voltage V_H drops and the second voltage V_L rises. For example, the first voltage V_H drops from the voltage V4 to the voltage V3, and the second voltage V_L rises from the voltage V1 to the voltage V2. Then, the CAN bus voltage difference, which is a voltage difference between the first voltage V_H and the second voltage V_L, becomes smaller than the threshold level, and the photodiode PD is turned off and does not emit light. Accordingly, the phototransistor PT may also be turned off. Since the wake-up holding signal HS is applied to the base of the control transistor 41 at the turn-on level, the power transistor 42 is maintained in a turn-on state. After being woken up, the battery management system 20 may maintain the wake-up holding signal HS at the turn-on level until time T5 when required operations are completed.

The battery management system 20 generates a relay open signal RO at a turn-on level at time T4. The relay 44 is opened by the relay open signal RO at the turn-on level. Therefore, after the time T4, the wake-up circuit 40 does not affect voltages transmitted through the CAN bus CAN_H and the CAN bus CAN_L. The time T4 may be any time after the time T3.

In FIG. 4, portions in which the first voltage V_H and the second voltage V_L are hatched indicate that levels of voltages transmitted through the CAN bus CAN_H and the CAN bus CAN_L after the wakeup are not limited. The first voltage (V_H) and the second voltage (V_L) after the wake-up may vary depending on voltages transmitted by any CAN transceiver to the CAN bus CAN_H and the CAN bus CAN_L.

Conventionally, the battery management system is maintained in an inactive state in a low-power mode and is selectively woken up based on a sub-block message according to the protocol. However, in the wake-up method according to the present disclosure, the battery management system can be woken up based on a difference between voltages transmitted through the two CAN buses without maintaining the battery management system in a low-power mode. Therefore, the battery management system according to the present disclosure can stand by for a long period of time in a sleep mode.

Although the exemplary embodiments of the present disclosure have been described in detail above, the scope of the present disclosure is not limited thereto. The scope of the invention is defined by the appended claims.

## Claims

1. A battery system (100) including a power supply (50), a battery pack (10) including a plurality of battery cells (10), a battery management system (20) adapted to monitor and manage the battery pack (10), a first CAN bus line (CAN_L), a second CAN bus line (CAN_H), and a wake-up circuit (40) adapted to control connection between the power supply (50) and the battery management system (20), the wake-up circuit (40) comprising:
a) an optocoupler (43) including a photodiode (PD) connected between the first CAN bus line (CAN_L) and the second CAN bus line (CAN_H) and a phototransistor (PT) adapted to turn on when the photodiode (PD) emits light;
b) a control transistor (41) adapted to turn on when the phototransistor (PT) is turned on; and
c) a power transistor (42) adapted to turn on when the control transistor (41) is turned on to connect the power supply (50) and the battery management system (20) to each other,
d) wherein the photodiode (PD) is adapted to turn on to emit light in a first time period (T1, T3) from a first time (T1) when a CAN bus voltage difference, which is a voltage difference between a first voltage of the first CAN bus line (CAN_L) and a second voltage of the second CAN bus line (CAN_H), becomes greater than or equal to a predetermined threshold level to a third time (T3) when the voltage difference becomes smaller than the predetermined threshold level;
e) wherein the battery management system (20) is adapted to apply a wake-up holding signal (HS) to the base of the control transistor (41) in a second time period (T2, T5) from a second time (T2) within the first time period to a fifth time (T5) when required operations are completed; and
f) wherein the wake-up circuit (40) further comprises:
a relay (44, 51) connected between the photodiode (PD) and any one of the first CAN bus line (CAN_L) and the second CAN bus line (CAN_H), wherein the battery management system (20) is adapted to generate a relay open signal (RO) to the relay (44, 51) to open within a third time period starting at a fourth time (T4) after the third time (T3) and before the fifth time (T5).

2. The battery system of claim 1, the wake-up circuit (40) further comprising:
a first low-pass filter (R1, C1) connected between the first CAN bus line (CAN_L) and the second CAN bus line (CAN_H) and the photodiode (PD);
wherein the CAN bus voltage difference is transmitted to the photodiode (PD) through the first low-pass filter (R1, C1).

3. The battery system of any one of claims 1 to 2, wherein
the power supply (50) is connected to one terminal of the phototransistor (PT), and a control terminal of the control transistor (41) is connected to the other terminal of the phototransistor (PT).

4. The battery system of claim 1, the wake-up circuit (40) further comprising:
a second low-pass filter (R2, C2) connected between the other terminal of the phototransistor (PT) and the control terminal of the control transistor (41).

5. The battery system of claim 1 or 4, the wake-up circuit (40) further comprising:
a resistor (R3) connected between the control terminal and one terminal of the control transistor (41),
wherein the other terminal of the control transistor (41) is connected to a gate of the power transistor (42).

## Patentansprüche

1. Batteriesystem (100), aufweisend eine Stromversorgung (50), einen Batteriepack (10), der eine Vielzahl von Batteriezellen (10) aufweist, ein Batteriemanagementsystem (20), das dazu eingerichtet ist, den Batteriepack (10) zu überwachen und zu verwalten, eine erste CAN-Bus-Leitung (CAN_L), eine zweite CAN-Bus-Leitung (CAN_H) und eine Aufweckschaltung (40), die dazu eingerichtet ist, die Verbindung zwischen der Stromversorgung (50) und dem Batteriemanagementsystem (20) zu steuern, wobei die Aufweckschaltung (40) Folgendes umfasst:
a) einen Optokoppler (43), der eine Fotodiode (PD), die zwischen der ersten CAN-Bus-Leitung (CAN_L) und der zweiten CAN-Bus-Leitung (CAN_H) geschaltet ist, und einen Fototransistor (PT), der dazu eingerichtet ist, einzuschalten, wenn die Fotodiode (PD) Licht emittiert, aufweist;
b) einen Steuertransistor (41), der dazu eingerichtet ist, einzuschalten, wenn der Fototransistor (PT) eingeschaltet wird; und
c) einen Leistungstransistor (42), der dazu eingerichtet ist, einzuschalten, wenn der Steuertransistor (41) eingeschaltet wird, um die Stromversorgung (50) und das Batteriemanagementsystem (20) miteinander zu verbinden,
d) wobei die Fotodiode (PD) dazu eingerichtet ist, einzuschalten, um in einem ersten Zeitraum (T1, T3) von einem ersten Zeitpunkt (T1), zu dem eine CAN-Bus-Spannungsdifferenz, die eine Spannungsdifferenz zwischen einer ersten Spannung der ersten CAN-Bus-Leitung (CAN_L) und einer zweiten Spannung der zweiten CAN-Bus-Leitung (CAN_H) ist, größer als ein vorbestimmter Schwellenwert oder gleich diesem wird, bis zu einem dritten Zeitpunkt (T3), zu dem die Spannungsdifferenz kleiner als der vorbestimmte Schwellenwert wird, Licht zu emittieren;
e) wobei das Batteriemanagementsystem (20) dazu eingerichtet ist, in einem zweiten Zeitraum (T2, T5) von einem zweiten Zeitpunkt (T2) innerhalb des ersten Zeitraums bis zu einem fünften Zeitpunkt (T5), zu dem erforderliche Vorgänge abgeschlossen sind, ein Aufweckhaltesignal (HS) an die Basis des Steuertransistors (41) anzulegen; und
f) wobei die Aufweckschaltung (40) ferner Folgendes umfasst:
ein Relais (44, 51), das zwischen der Fotodiode (PD) und entweder der ersten CAN-Bus-Leitung (CAN_L) oder der zweiten CAN-Bus-Leitung (CAN_H) geschaltet ist, wobei das Batteriemanagementsystem (20) dazu eingerichtet ist, ein an das Relais (44, 51) gerichtetes Relaisöffnungssignal (RO) zu erzeugen, damit das Relais innerhalb eines dritten Zeitraums öffnet, der zu einem vierten Zeitpunkt (T4) nach dem dritten Zeitpunkt (T3) und vor dem fünften Zeitpunkt (T5) beginnt.

2. Batteriesystem nach Anspruch 1, wobei die Aufweckschaltung (40) ferner Folgendes umfasst:
ein erstes Tiefpassfilter (R1, C1), das zwischen der ersten CAN-Bus-Leitung (CAN_L) und der zweiten CAN-Bus-Leitung (CAN_H) und der Fotodiode (PD) geschaltet ist;
wobei die CAN-Bus-Spannungsdifferenz durch das erste Tiefpassfilter (R1, C1) an die Fotodiode (PD) übertragen wird.

3. Batteriesystem nach einem der Ansprüche 1 bis 2, wobei
die Stromversorgung (50) mit einem Anschluss des Fototransistors (PT) verbunden ist und ein Steueranschluss des Steuertransistors (41) mit dem anderen Anschluss des Fototransistors (PT) verbunden ist.

4. Batteriesystem nach Anspruch 1, wobei die Aufweckschaltung (40) ferner Folgendes umfasst:
ein zweites Tiefpassfilter (R2, C2), das zwischen dem anderen Anschluss des Fototransistors (PT) und dem Steueranschluss des Steuertransistors (41) geschaltet ist.

5. Batteriesystem nach Anspruch 1 oder 4, wobei die Aufweckschaltung (40) ferner Folgendes umfasst:
einen Widerstand (R3), der zwischen dem Steueranschluss und einem Anschluss des Steuertransistors (41) geschaltet ist,
wobei der andere Anschluss des Steuertransistors (41) mit einem Gate des Leistungstransistors (42) verbunden ist.

## Revendications

1. Système de batterie (100), comprenant une alimentation électrique (50), un bloc-batterie (10) comprenant une pluralité de cellules de batterie (10), un système de gestion de batterie (20) prévu pour surveiller et gérer le bloc-batterie (10), une première ligne de bus CAN (CAN_L), une deuxième ligne de bus CAN (CAN_H) et un circuit d'activation (40) prévu pour commander la connexion entre l'alimentation électrique (50) et le système de gestion de batterie (20), ledit circuit d'activation (40) comprenant :
a) un optocoupleur (43) présentant une photodiode (PD) connectée entre la première ligne de bus CAN (CAN_L) et la deuxième ligne de bus CAN (CAN_H) et un phototransistor (PT) prévu pour être activé lorsque la photodiode (PD) émet de la lumière ;
b) un transistor de commande (41) prévu pour être activé lorsque le phototransistor (PT) est activé ; et
c) un transistor de puissance (42) prévu pour être activé lorsque le transistor de commande (41) est activé afin de connecter l'alimentation électrique (50) et le système de gestion de batterie (20) entre eux,
d) où la photodiode (PD) est prévue pour être activée afin d'émettre de la lumière pendant une première période (T1, T3) allant d'un premier moment (T1) où une différence de tension de bus CAN, laquelle est une différence de tension entre une première tension de la première ligne de bus CAN (CAN_L) et une deuxième tension de la deuxième ligne de bus CAN (CAN_H), devient supérieure ou égale à un niveau de seuil prédéterminé, à un troisième moment (T3) où la différence de tension devient inférieure au niveau de seuil prédéterminé ;
e) où le système de gestion de batterie (20) est prévu pour appliquer un signal de maintien d'activation (HS) à la base du transistor de commande (41) pendant une deuxième période (T2, T5) allant d'un deuxième moment (T2) pendant la première période à un cinquième moment (T5) où les opérations requises sont terminées ; et
f) où le circuit d'activation (40) comprend en outre :
un relais (44, 51) connecté entre la photodiode (PD) et une ligne quelconque entre la première ligne de bus CAN (CAN_L) et la deuxième ligne de bus CAN (CAN_H), le système de gestion de batterie (20) étant prévu pour générer un signal d'ouverture de relais (RO) vers le relais (44, 51) à ouvrir pendant une troisième période allant d'un quatrième moment (T4) après le troisième moment (T3) et avant le cinquième moment (T5).

2. Système de batterie selon la revendication 1, où le circuit d'activation (40) comprend en outre :
un premier filtre passe-bas (R1, C1) connecté entre la première ligne de bus CAN (CAN_L) et la deuxième ligne de bus CAN (CAN_H) et la photodiode (PD) ;
où la différence de tension de bus CAN est transmise à la photodiode (PD) par le premier filtre passe-bas (R1, C1).

3. Système de batterie selon la revendication 1 ou la revendication 2, où l'alimentation électrique (50) est connectée à une première borne du phototransistor (PT), et une borne de commande du transistor de commande (41) est connectée à l'autre borne du phototransistor (PT).

4. Système de batterie selon la revendication 1, où le circuit d'activation (40) comprend en outre :
un deuxième filtre passe-bas (R2, C2) connecté entre l'autre borne du phototransistor (PT) et la borne de commande du transistor de commande (41).

5. Système de batterie selon la revendication 1 ou la revendication 4, où le circuit d'activation (40) comprend en outre :
une résistance (R3) connectée entre la borne de commande et une première borne du transistor de commande (41),
où l'autre borne du transistor de commande (41) est connectée à une grille du transistor de puissance (42).
